# EUROPEAN PATENT APPLICATION

(11) **EP 1 174 679 A2**
(43) Date of publication of application: **23.01.2002**
(21) Application number: 01116719.4
(22) Date of filing: 18.07.2001
(51) Int. Cl.: G01B 9/02

(54) **Interferometer box**

(30) Priority: 18.07.2000 US 618892
(71) Applicant: Nikon Corporation, Tokyo 140 (JP)
(72) Inventor: Lee, Martin E., Saratoga, CA 95070 (US)
(74) Representative: HOFFMANN - EITLE

(57) **Abstract**

An interferometer assembly and imaging apparatus incorporating the interferometer assembly. The interferometer assembly is configured to measure the position of a reticle or substrate positioning assembly relative to the position of the end of an image reduction assembly closest to the reticle or substrate positioning stage whose position is being measured. The interferometer assembly has interferometers for determining the position of the positioning assembly in one dimension, and the interferometer also has interferometers for determining in three dimensions the position of the portion of the image reduction assembly closest to the interferometer assembly. The imaging apparatus uses signals generated by the interferometer assembly to accurately position a positioning stage relative to the image reduction apparatus. Also disclosed is a method for forming an image using the imaging apparatus.

## Description

### TECHNICAL FIELD OF THE INVENTION

The invention provides an imaging apparatus such as a photolithographic or e-beam step and scan assembly that provides more accurate indications of alignment inaccuracies caused by vibration and also compensates for those inaccuracies.

### BACKGROUND

Lithographic equipment has played a critical role in advances in electronics processing. Lithographic equipment forms the precisely-dimensioned images that are needed to establish circuit elements and circuit layout. It is increasingly difficult to form accurately-dimensioned images as features on substrates are formed to smaller and smaller sizes and higher density. Very small movements in components of the lithographic equipment from e.g. equipment vibration or a temperature differential can produce images offset from their desired locations. These inaccuracies compound as additional features are formed in subsequent steps when processing the substrate. The various components that make up circuit elements must be sized much larger than their ideal size to allow for variances in the positions of the components.

Manufacturers of lithographic equipment have devoted substantial resources to reducing and eliminating vibration and other movement of equipment components where possible. Despite the reductions in vibration and component movement that manufacturers have already achieved, vibration and equipment movement remains as one of the most significant problems when forming lithographic images today.

Manufacturers have provided sophisticated measurement equipment to determine the relative position of stages to one another, and they have tried to reduce the effects that vibration has on image formation by utilizing the interferometers to give precise measurements of the relative position of the reticle positioning assembly to the substrate positioning assembly. To further understand the problems that persist when trying to form accurately-positioned images, a brief discussion of lithography as applied to semiconductor manufacturing is provided.

A reticle embodies the image that is to be formed on the substrate. The image formed by passing radiation (such as light from an excimer laser or e-beams or x-rays from a generator) through the reticle is reduced in size by an image reduction assembly (such as a lens assembly), and the reduced image exposes a small portion of the substrate that has been positioned beneath the image reduction assembly by the substrate positioning assembly. The substrate is repositioned by moving the substrate positioning assembly, and a different small portion of the substrate is exposed to the light pattern. This continues until the substrate is completely exposed.

In step and scan lithography as is currently practiced, the reticle contains an image that is larger than the lens and its exposure field can accommodate without moving the reticle. When forming a reduced image on a substrate, the substrate and reticle are positioned, and the radiation source exposes a portion of the substrate. The substrate and reticle are moved by the substrate positioning assembly and the reticle positioning assembly, respectively, while exposure continues to occur to form the desired image on the substrate. The substrate is then stepped to its next position and the method described above is repeated to allow the full image to be formed at another position on the substrate.

As the reticle positioning assembly and substrate positioning assembly move, vibrations are created and introduced into these assemblies as weii as the image reduction assembly and the various supports used to hold the equipment. Further, minor temperature variations or gradients cause portions of the equipment to move relative to one another.

One significant problem has been rotation of the image reduction assembly. The image reduction assembly is a large piece of equipment that is attached to a support. Vibrations, temperature gradients, and temperature fluctuations cause the assembly to rotate so that its optical axis no longer corresponds to the z axis. The optical axis can be offset in the x and/or y direction because of vibration and temperature change. If this rotation is not accounted for when positioning the substrate and reticle, the image will not be formed on the substrate in the desired location.

Thus, any positional inaccuracies in the reticle positioning assembly, the image reduction assembly, and the substrate positioning assembly caused by vibration and/or temperature gradients and variations affect the accuracy of placing the image on the substrate. A portion of the image formed on the substrate can be offset in x and/or y directions because of vibration and/or rotation. Minor inaccuracies in positioning one stage relative to the other can cause significant problems in device manufacturing as dimensions of the devices shrink and as alignment tolerances shrink.

Consequently, a system that accommodates rotation in the image reduction assembly and provides a very precise indication of reticle and/or substrate position would allow images to be formed on the substrate very accurately.

### SUMMARY OF THE INVENTION

It is an object of the invention to provide an interferometer assembly that monitors the relative difference between a reticle or substrate positioning assembly and the portion of an image reduction assembly that is closest to the positioning assembly.

It is another object of the invention to provide an imaging apparatus that accurately positions a reticle or substrate positioning assembly despite vibrations that can otherwise provide false readings of position of the reticle or substrate positioning assembly.

It is another object of the invention to precisely position a reticle or substrate positioning assembly in response to rotation in the image reduction assembly of an imaging apparatus.

It is a further object of the invention to provide a method of detecting the movement of an interferometer assembly relative to an image reduction assembly and a positioning assembly and compensating for this movement to assure that the positioning assembly maintains a desired relationship to the image reduction assembly.

The invention provides an interferometer assembly and an imaging apparatus such as a photolithographic or e-beam step and scan assembly that provides a more accurate indication of alignment inaccuracies caused by vibration and also compensates for those inaccuracies.

The interferometer assembly provides accurate measurements of the position of a reticle positioning assembly or a substrate positioning assembly (such as an X-Y stage) to an image reduction assembly of the imaging apparatus in two axes (such as X and yaw or Y and yaw or X and Y). In one embodiment of the invention, the interferometer assembly has a rigid housing and at least three interferometers mounted rigidly in the rigid housing. The rigid housing is reinforced to prevent flexing, and the interferometers are mounted sufficiently closely to one another on the rigid housing so that each interferometer has essentially no movement relative to the other interferometers. The interferometers are positioned two-dimensionally to one another, such as in a row and column configuration, so that the two (e.g. row-mounted) interferometers can monitor distances to a mirror mounted to the positioning assembly or the image reduction assembly. Differences between these measured distances also indicate whether the assembly to which the mirror is mounted has rotated about a vertical axis. The two vertical interferometers provide a measure of how much rotation from a true vertical position the assembly to which the mirror is mounted has experienced.

The phrase "two-dimensionally" is used to indicate that the interferometers are viewed to be in an array when viewed from a direction parallel to the measurement beams that contact the mirrors on the imaging apparatus. The use of the phrase "two-dimensionally" does not preclude the interferometers from being positioned at different depths from one another or from being arranged in a non-orthogonal array, although an orthogonal array is preferred.

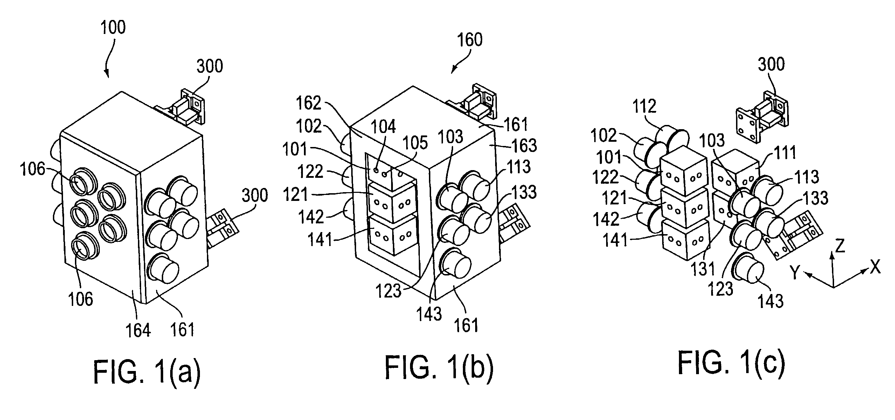

In another, preferred embodiment of the invention, the interferometer assembly comprises at least five interferometers in a rigid housing. The five interferometers are arranged two-dimensionally to one another, as in a configuration of two rows and two columns as illustrated in Figure 1. Two interferometers measure the position of a positioning stage, and three interferometers measure the position, torque, and rotation that an image reduction assembly has experienced.

Either or both of the above-described interferometer assemblies are part of an imaging apparatus that comprises one or more of these interferometer assemblies, a reticle positioning stage, a substrate positioning stage, and an imaging assembly such as an image reduction assembly. Radiation from an illuminator, such as laser light from an excimer laser, electron beams from an electron beam generator, or other source of radiation suitable to expose a polymeric coating on a wafer or substrate, illuminates the reticle or a portion of the reticle, and the pattern of radiation travels through the image reduction assembly to be reduced in size and projected onto a substrate carried by the substrate positioning assembly. The imaging apparatus can be enclosed within an enclosure and operate under vacuum.

The interferometer assembly can be mounted to the remainder of the imaging apparatus through isolation blocks that isolate the assembly from vibrations that the lens assembly and reticle assembly experience. In a preferred embodiment, the interferometer assembly is mounted to a support through a gimbal and flexure mount that further solates the assembly from any stress that the support experiences which could change the position of an interferometer relative to the other interferometers within its housing.

The invention also provides a method of accurately forming an image on a substrate using at least one of the interferometer assemblies described above as part of an imaging apparatus. The method comprises illuminating the reticle so that light passes through the reticle and the image reduction assembly or other imaging assembly and to the substrate being processed, moving the reticle and substrate using a reticle positioning assembly and a substrate positioning assembly, and accurately positioning each of the positioning assemblies by determining their positions relative to their respective ends of the image reduction assembly using an interferometer assembly that measures the position of a positioning stage relative to the position of the end of the image reduction assembly closest to the positioning stage and adjusting the positions of the substrate and reticle until the desired position is achieved.

The invention also provides a method of determining mirror flatness. A map of mirror flatness can be stored in, e.g., computer memory and used to more accurately position a positioning stage by accounting for mirror imperfections that would otherwise cause the positioning stage to be misplaced when positioning the positioning stage. The method comprises moving the mirror normal to light beams from a first set of two interferometers that form part of an interferometer assembly as described above; measuring the distance that the mirror has moved and maintaining the mirror normal to the beams by using a second set of an additional two interferometers to monitor the position of a reference mirror and removing any rotation tha the reference mirror experiences during movement as indicated by differences in distance reported by the two interferometers, the reference mirror itself being normal to the mirror whose flatness is being mapped and being maintained in fixed relationship to the mirror being mapped; measuring the distance from the first set of interferometers to the mirror whose flatness is to be determined; and correlating the distance reported by the first set of interferometers with the position of the moving mirror as reported by the second set of interferometers.

Among other factors, the invention is based on the technical finding that an interferometer assembly having at least three interferometers in a rigid housing as described herein, when incorporated into an imaging apparatus having a reticle positioning assembly, image reduction assembly (such as a lens assembly), and substrate positioning assembly within an enclosure, provides accurate placement of the reticle in relation to the image reduction mechanism and also provides accurate placement of the substrate in relation to that image reduction mechanism. The image formed on the substrate by passing e.g. light or e-beam energy through the reticle and the image reduction assembly is very accurately aligned to other features already formed on the substrate. Further, the use of a mirror flatness map that has been derived using the interferometer assemblies and imaging apparatus of the invention provides for a higher degree of accuracy when illuminating a substrate with images. These technical findings and advantages and others are apparent from the disclosure herein.

### BRIEF DESCRIPTION OF THE FIGURES

Figure 1(a) illustrates an assembled interferometer assembly 100 in which a front plate 164 and three kinematic mounts 300 are attached to the rigid box 161 of the assembly. Tnere are five quarter-wave plates 106 on the front of the interferometer box. Light from a laser enters the interferometer assembly from the rear (i.e. the portion of the assembly to which cross flexures 300 are attached), and the interferometer position data output (i.e. the light beam after it has passed through the interferometers and been reflected by target mirrors) exits the interferometer assembly from the rear. Interferometer measurement beams exit from and are reflected back through the quarter-wave plate windows 106.

Figure 1(b) illustrates an interferometer assembly (with front plate removed) having individual interferometers comprised of a beam splitter (e.g. 101) and two comer cubes (e.g. 102 and 103) per beam splitter. This figure illustrates a column of beam splitters mounted to a wall of the rigid box.

Figure 1(c) illustrates a configuration of five beam splitters, ten comer cubes (some of which are hidden from view by the beam splitters), and three kinematic mounts (one of which is almost totally obscured from view by beam splitters 111 and 131) in their positions within rigid box 161 if the rigid box is dissolved from view.

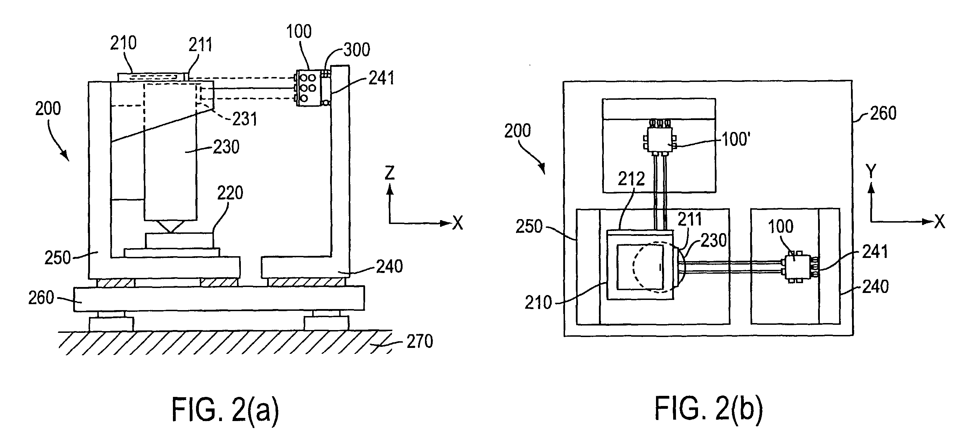

Figure 2(a) is a side view and Figure 2(b) is a top view of an imaging system that incorporates two interferometer assemblies 100 (a five-interferometer assembly) and 100' (a three-interferometer assembly) with a reticle positioning assembly, a substrate positioning assembly, and an image reduction assembly.

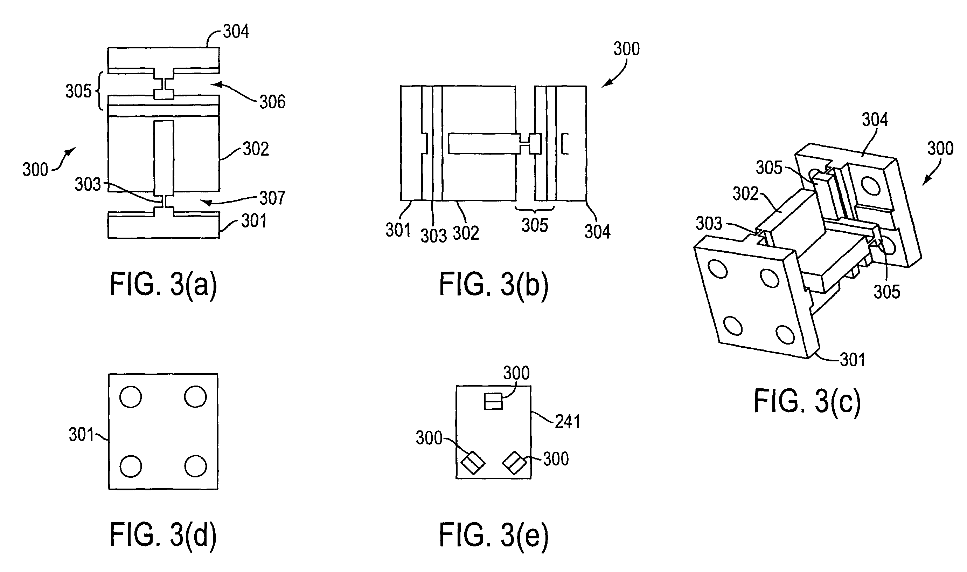

Figure 3(a) illustrates a side view of a cross flexure 300 showing flexure 303 on end, and Figure 3(b) illustrates the same cross flexure rotated 90° so that flexure 303 is viewed from the side. Figure 3(c) illustrates the same cross flexure 300 from a different angle, showing further detail of the gimbaled end 306. Figure 3(d) depicts the cross flexure 300 as viewed from the single flexure end 307 of the cross flexure. Figure 3(e) illustrates the particular arrangement of three cross flexures 300 mounted to a surface 241 of the interferometer assembly support 240. The three flexures are mounted about 120° from one another along the radius of a circle, and the single flexure end is attached to the surface of the interferometer assembly support so that the single flexure is tangent to the circle and thus perpendicular to the radius of the circle. This arrangement helps to cancel or minimize changes in forces that the interferometer assembly would experience through the interferometer assembly support as the supporting wall is stressed by external forces while also allowing for radial lift of the kinematic mount. The three cross flexures so positioned help to ensure that the interferometer box to which they are mounted does not distort.

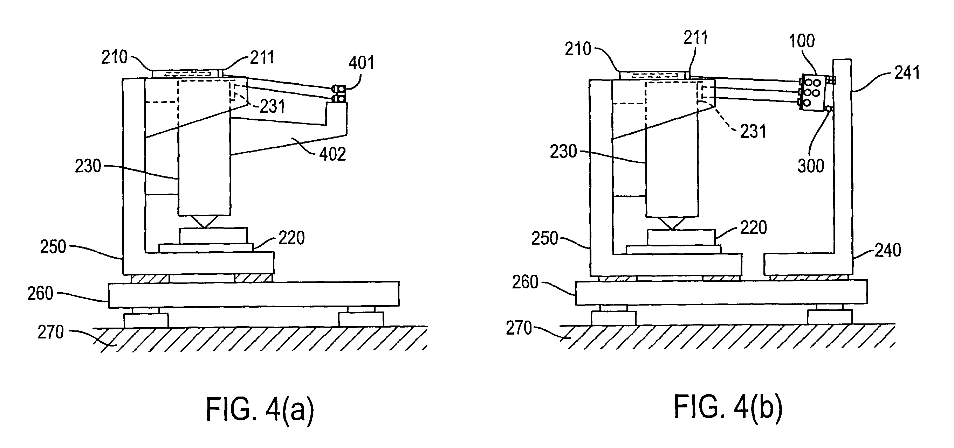

Figure 4(a) illustrates an imaging unit that is not within the scope of the invention. This imaging unit has interferometers mounted at the end of an arm attached to the image reduction assembly. The interferometers do not measure rotation that the image reduction assembly experiences, and consequently this imaging unit does not position the reticle positioning stage in the desired relationship to the image reduction stage because of an error in the interferometers' measurement. This unit provides an erroneous indication of the reticle stage if there is a tilt. For example, if the support arm 402 is twenty-four inches (about 61 cm) long, a 0.001 inch (about 0.025 mm) vertical motion of the interferometer box can cause a tilt of the interferometers from beam to beam of about 80 microinch (about 2 micron), assuming that the distance between the two beams is 2 inches (about 5.1 cm). This tilt can be caused by e.g. a temperature gradient on the interferometer support arm.

Figure 4(b) illustrates an imaging assembly that is within the scope of the invention. This imaging assembly accounts for rotation in the image reduction assembly because interferometer assembly 100 has interferometers that measure both the relative position of the reticle positioning assembly to the image reduction assembly and the amount of rotation that the image reduction assembly experiences relative to the interferometer assembly.

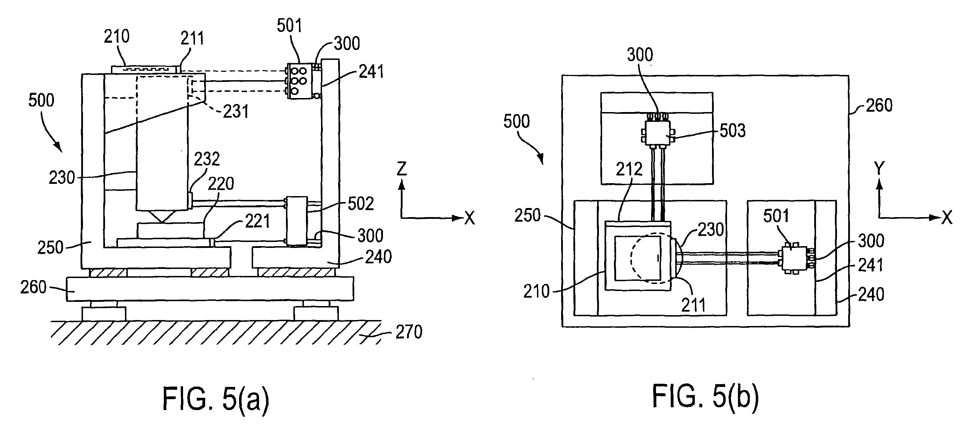

Figure 5(a) is a side view and Figure 5(b) is a top view of another imaging assembly of the invention. This preferred assembly has two interferometer assemblies as illustrated in Figure 1(a). Each interferometer assembly measures the position of a positioning assembly relative to the position of the nearest portion of the image reduction assembly. Each of the interferometer assemblies provides an indication of the extent that the nearest portion of the image reduction assembly has rotated with regard to the nearest interferometer assembly. Each stage can therefore be positioned very accurately in relation to its closest end of the image reduction assembly, and extremely accurate placement of images upon the substrate is thus provided.

### DETAILED DESCRIPTION OF THE PREFERRED EMBODIMENT

One interferometer assembly of the invention is illustrated in Figure 1. The interferometer assembly 100 of Figure 1(a) enables accurate placement of both substrate and reticle positioning assemblies and also accommodates rotation in the imaging or image reduction assembly that would otherwise cause substantial inaccuracies in the position of the reduced image on the substrate.

Interferometer assembly 100 provides a number of interferometers that are maintained in essentially the same position relative to one another. This interferometer assembly 100 has five interferometers, each of which is comprised of a beam splitter (101, 111, 121, 131, and 141) and two corner cubes (102 and 103, 112 and 113, 122 and 123, 132 (not shown for the sake of clarity) and 133, and 142 and 143, respectively). Such interferometers are well-known in the art, and the following description of their operation is thus general in nature. Linearly-polarized laser light enters a beam splitter (e.g. 101) and is split into two beams polarized 90° to one another. Beam splitter 101 reflects one polarized mode into one comer cube 102 and again reflects that beam back along a path parallel to the incoming beam and to an analyzer. This beam is the reference beam for the interferometer. The other polarized mode passes through the beam splitter at hole 104 and through a quarter-wave plate (not shown for sake of clarity) positioned between beam splitter 101 and its target mirror (e.g. planar mirror 211). This beam is the measurement beam. The reflected beam passes through the quarter-wave plate and through hole 104 to beam splitter 101, which reflects the beam to edge cube 103. Edge cube 103 reflects the measurement beam to the beam splitter 101, which directs the beam through hole 105 and the quarter-wave plate to a different position along planar mirror 211. Mirror 211 reflects the measurement beam through the quarter-wave plate and hole 105, and the beam passes out of the beam splitter along a path parallel to the incoming beam to the analyzer. The analyzer compares the reference beam and the measurement beam to determine the change in distance between beam splitter 101 and mirror 211.

Beam splitters 101, 121, and 141 are mounted to one wall 162 of the rigid nousing 160, comprised of a thick-walled box 161, a front plate 164, and a back plate (not shown for purposes of clarity). Beam splitters 101, 121, and 141 are mounted to wall 162 in vertical alignment with one another along the z axis. Beam splitters 111 and 131 are mounted to opposite wall 163, also in vertical alignment with one another along the z axis. Beam splitters 111 and 131 are offset from beam splitters 101, 121, and 141 in both the x and y directions to provide an unimpeded path for the laser beams emerging from the beam splitters and traveling to the corner cubes. The offset in x, y, and z directions is kept very small so that the thick-walled box 161 remains small and thus very rigid. The walls of box 162 are thick to provide structural rigidity to the box, and the front plate 164 (in which the quarter-wave plates are mounted) and back plate for the box brace the walls to add further rigidity. The back plate also has an access window that is transparent to laser light so that the beam enters the box unimpeded.

Figure 2 illustrates an imaging apparatus 200 into which interferometer assembly 100 of Figure 1 is incorporated. The imaging apparatus has a reticle positioning assembly 210 such as a reticle stage, a substrate positioning assembly 220 such as a substrate stage, an image reduction assembly 230 such as a lens assembly, and at least one interferometer assembly 100 or 100' as illustrated in Figure 1. Interferometer assembly 100 is attached to a mounting surface 241, a portion of a vertical interferometer assembly support 240 or, alternatively, a portion of a side-wall of an enclosure that forms a vacuum chamber in which the imaging apparatus is located. Image reduction assembly 230 is attached to an imaging system base 250 that carries the reticle positioning assembly 210 and the substrate positioning assembly 220 as well. The interferometer assembly support 240 and the imaging system base 250 are attached to a machine base 260 that sits upon the floor 270.

Light from the five interferometers of the interferometer assembly is reflected from various reflective surfaces to provide measures of relative distance. For example, light beams from beam splitters 101 and 111 of interferometer assembly 100 reflect from a mirror 211 mounted on the reticle positioning assembly. Light beams from beam splitters 121 and 131 reflect from a mirror 231 on the image reduction assembly 230. The relative x position of the reticle positioning assembly in relation to the image reduction assembly 230 is thus determined by the interferometer system which incorporates beam splitters 101 and 111 and 121 and 131 and its other components such as mirrors, quarter-wave plates, polarization analyzer, and associated electronics.

As noted above, the image reduction assembly can rotate such that its axis no longer corresponds to or is parallel to the z axis. The top portion of the image reduction assembly may be closer to the imaging system base 250 and the bottom portion of the image reduction assembly may be further from the imaging system base 250 during operation than occurs when the assembly is static and not in operation. This rotation is calculated by comparing the measurements of the interferometer system which incorporates beam splitters 121, 131, and 141. When rotation as described above occurs, light travels a distance from beam splitter 121 to mirror 231 essentially equal to the distance from beam splitter 141 to mirror 231. However, there is a significant difference between the distance that light travels from beam splitter 121 to mirror 231 and the distance light travels from beam splitter 131 to mirror 231. The amount of rotation can be calculated, and both the reticle positioning assembly 210 and substrate positioning assembly 220 can be positioned to compensate for the rotation in image reduction assembly 230.

The three beam splitters 121, 131, and 141 may be placed in any spatial relationship to one another but are preferably placed in rows and columns as shown to simplify calculations that represent the relative position of the plane that the three interferometers are monitoring. The two beam splitters 101 and 111 are preferably placed so that their beams impinge their corresponding stage's mirror at the same elevation, so that any tilt in the stage does not introduce error when measuring the x or y positions of the stage.

The interferometer assembly of Figure 1 is mounted to a mounting surface through three kinematic mounts. A kinematic mount is one where the number of degrees of freedom (axes of free motion) and the number of physical constraints applied to the mount are identical. A kinematic mount, therefore, has no redundant physical constraints applied to the mount. A kinematic optical mount consequently has six independent constraints.

One preferred kinematic mount 300 incorporating a gimbal assembly is illustrated in Figure 3. One end of the mount has a first mounting plate 301 that is attached to a center body 302 through a flexure such as thin plate 303. The other end of the mount has a second mounting plate 304 attached to the center body 302 through a gimbal assembly such as a universal joint or a cross flexure 305, as illustrated in the Figure.

A kinematic flexure-type mount as illustrated has little "stiction" and also helps to eliminate any stress changes to which an object would otherwise be subjected if a kinematic mount were not used. Since the mount has a gimbaled end, the mount allows angular rotation in all planes. A gimbaled end helps to reduce or eliminate any "stiction" or hysteresis that might otherwise subject the interferometer assembly to unwanted vibration as well as prevent the object to which the mount is attached from being rotated, torqued, or otherwise distorted.

The gimbal end of the kinematic mount having gimbal assembly 305 is attached to the interferometer assembly, and the flexure end of the kinematic mount having flexure 303 is attached to the supporting surface for the interferometer assembly as illustrated in Figure 1(a), 1(c), and 2(a). Three of these kinematic mounts are attached to the interferometer assembly and the supporting surface as illustrated in Figure 1(a) and 3(e). This configuration of interferometer assembly, kinematic mounts, and supporting surface functions as a three ball, three radial slot system having little resistance to movement yet also having an inherent configuration that helps to balance or counteract any forces induced on the interferometer assembly through one of the kinematic mounts. These kinematic mounts also have little friction compared to a three ball, three radial slot system.

For example, if the mounting surface distorts so that the first mounting plates of the three kinematic mounts no longer lie in the same plane, the flexures and gimbaled ends of the kinematic mounts move sufficiently that the housing of the interferometer assembly attached to the gimbaled end of the kinematic mounts is subjected to little or no force that might distort the housing. Because of the ability to prevent the interferometer assembly from distorting even though the surface to which the assembly is attached is distorting, the interferometer assembly can be mounted to internal or external sidewalls of a vacuum chamber that deform significantly as a high vacuum is drawn on the chamber. Measurement accuracy of movement or position of the reticle positioning assembly relative to the image reduction assembly is thus maintained quite high. Further, by placing the cross flexure near the interferometer assembly, vibration induced moments that could distort the box are minimized.

Two of the interferometer assemblies just described can be used as x and y position indicators, as illustrated in Figure 2(b). One interferometer assembly monitors movement of the reticle positioning system in the x direction and image reduction system rotation, and the other interferometer assembly monitors movement of the reticle positioning system in the y direction. The second interferometer assembly would require only three interferometers, although five or more could be used in order to obtain more accurate measurements of rotation as well as reticle position. Thus the interferometers made of beam splitter 131 and 141 and their associated components could be eliminated.

Interferometer assemblies can be used to determine the position of the substrate positioning assembly and rotation of the bottom portion of the image reduction system. The assembly of Figure 1 could be positioned so that beams from beam splitters 101 and 111 reflect from a mirror positioned on the substrate positioning assembly to monitor its motion in the x direction, and beams from beam splitters 121, 131, and 141 reflect off of a mirror positioned on the bottom portion of the image reduction system. A second interferometer assembly with three interferometers could be used to monitor movement in the y direction. In some instances, it is sufficient to monitor rotation once at each end of the image reduction assembly. Consequently, one of the four interferometer assemblies used to measure x and y movement of the reticle and substrate positioning assemblies would have five or more interferometers, and the remaining interferometer assemblies could use only three interferometer assemblies.

The interferometer assembly illustrated in Figure 1 can be two separate units instead of one. In one unit, a rigid housing contains three interferometers, one that reflects from the reticle positioning assembly and two, one above the other, that reflect from the image reduction assembly. This first unit measures, e.g., the x position of the reticle positioning assembly. The second unit comprises a second rigid housing containing another two interferometers, one of which reflects from a mirror on the image reduction assembly and the other of which reflects from the reticle positioning assembly, to calculate the amount of rotation that the image reduction assembly is experiencing.

Figure 4(b) illustrates the advantages of the interferometer assembly of the invention as compared to another interferometer mounted on a rigid arm. In Figure 4(a), the four interferometers that are mounted as a unit 401 on arm 402 provide an erroneous measurement if the unit tilts. The bottom two interferometers and top two interferometers have no way of identifying how much the unit has tilted. Assuming that arm 402 is 24 inches (about 61 cm) long, a vertical movement of 0.001 inch (about 0.25 micron) in the end of the arm caused by the arm vibrating creates an error in the unit's reading of about 2 micron, assuming that the vertical distance between the two beams is 2 inches (about 5.08 cm). If the interferometer assembly of Figure 4(b) is mounted on the same arm and subjected to the same movement as the interferometer unit of Figure 4(a), the five interferometers of the interferometer assembly provide readings that indicate that the interferometer assembly has tilted in relation to the image reduction assembly. Each reading from all five interferometers has changed, indicating movement of the interferometer assembly. The control system can thus compensate for the movement and accurately position the reticle positioning assembly in relation to the image reduction assembly, since the control system has sufficient information to determine that all interferometers of the interferometer assembly have moved in relation to the reticle positioning assembly and the image reduction assembly. As a result, the interferometer assembly of Figure 4(b) allows accurate placement of the reticle positioning assembly relative to the image reduction assembly, especially when compared to the interferometer unit of Figure 4(a).

There are two additional benefits derived from an interferometer assembly that mounts to a vertical interferometer assembly support or sidewall of an enclosure for the imaging system. The interferometer housing can be made very small compared to the vertical interferometer assembly support or sidewall. The size of the housing is selected so that it holds the beam splitters and comer cubes but is not much bigger than needed to hold these components. The small size of the housing thus helps to provide the housing with high rigidity.

Further, the thick walls of the housing provide reinforcement that helps to stiffen the housing to provide further rigidity. The end plates also add rigidity when they are attached to the housing. The housing may additionally be reinforced by adding reinforcing ribs that make the housing more rigid. The housing of the interferometer assembly is thus very stiff, and it vibrates essentially as a rigid body vibrates. Since the interferometers for measuring position as well as rotation are within this housing, the motion of any interferometer relative to the others within the housing is minimized despite the interferometer assembly being subjected to the vibrations and stresses associated with operation and startup of the equipment monitored by the interferometer assembly.

An interferometer assembly is especially isolated from the vibrations associated with moving stages and the stresses associated with high vacuum within the enclosure of the imaging system when the interferometer assembly is mounted to the enclosure or a separate base within the enclosure via kinematic mounts. The kinematic mounts help to further isolate the rigid housing and other components of the interferometer assembly from the vibrations and stresses that the enclosure or base experience. Consequently, the interferometers of the interferometer assembly maintain their positions relative to one another, thus providing a high degree of dimensional stability so that errors are not introduced by one interferometer moving relative to another interferometer.

Further, an imaging system is easier to maintain where the interferometer assembly is mounted to a support that is separate from or independent of the image reduction assembly. The image reduction assembly is unencumbered by a mechanical arm to which the interferometer assembly would otherwise be attached. Thus, the image reduction assembly can be a unit mechanically separated from the interferometer assembly, facilitating easier maintenance.

One imaging apparatus 500 that is particularly preferred is one as illustrated in Figure 5, in which a first interferometer assembly 501 as illustrated in Figure 1 is situated to determine the position of the reticle positioning assembly 210 relative to the upper portion of the image reduction assembly 230 or other imaging assembly, and a second interferometer assembly 502 as illustrated in Figure 1 is placed to determine the position of the substrate positioning assembly 220 relative to the lower portion of the image reduction assembly 230 by reflecting light off of mirrors 221 and 232. Two other interferometer assemblies (503 and one not illustrated in Figure 5(b) but mounted below interferometer assembly 503 in Figure 5(b), each of these assemblies having three interferometers) are used to measure motion of the respective positioning assemblies in the y direction. This imaging apparatus is exceptionally accurate in forming images at the desired location on a substrate.

Imaging apparatus 500 compensates for movements such as rotation and vibration and maintains accurate placement of the reticle to the upper portion of the image reduction assembly as well as the substrate to the lower portion of the image reduction assembly. By making measurements of each positioning assembly relative to the portion of the image reduction assembly that is closest to the particular positioning assembly, the reticle can be accurately placed over the image reduction assembly so that light passing through the reticle enters the image reduction assembly at the proper location. Likewise, light exiting the image reduction assembly at a particular location contacts the substrate at the desired location because the substrate is accurately aligned to the lower portion of the image reduction assembly by the lower interferometer assembly.

Because the interferometer assembly measures the position of each positioning assembly relative to its closest portion of the image reduction assembly, relative movements can be detected and corrected, and any movement that does not affect the relative positions of the positioning assembly and the image reduction assembly can be ignored. For example, if the upper interferometer assembly moves only in the x direction so that it is closer to both the reticle positioning assembly and the image reduction assembly, the reticle positioning assembly is not moved because the difference between the distance from the interferometer assembly to the reticle positioning assembly and the distance from the interferometer assembly to the image reduction assembly remains constant.

If the lower portion of interferometer assembly tilts closer to image reduction assembly than does the upper portion of the interferometer assembly to the reticle positioning assembly but the reticle positioning assembly has not moved relative to the image reduction assembly, the interferometer assembly generates sufficient information to indicate there has been no relative movement between the reticle positioning assembly and the image reduction assembly. The set of beams generated by beam splitters 121 and 141, for instance, indicate that the bottom of the interferometer assembly is closer to the image reduction assembly than is the top because the distance from beam splitter 141 to the image reduction assembly is less than the distance from beam splitter 121 to the image reduction assembly. Through simple geometry, a system computer uses the distances measured to beam splitters 121 and 141 to determine the angle of tilt between the interferometer assembly and the image reduction assembly. The computer recalculates the distance that the beam splitters 101 and 111 should be from the reticle positioning assembly relative to the distance that beam splitters 121 and 131 are from the upper portion of the image reduction assembly. In this instance, the difference between the positions has not changed. The interferometer assembly provides sufficient information to determine this, and so the reticle positioning assembly is not moved.

The same situation applies if the difference between the position of the substrate positioning assembly and the position of the lower portion of the image reduction assembly is monitored using an interferometer assembly of the invention. The computer uses simple geometry to compensate for tilt between the interferometer assembly 502 and the image reduction assembly to determine the position of the substrate positioning assembly relative to the lower portion of the image reduction assembly.

Because this preferred imaging system utilizes upper and lower interferometer assemblies to monitor the relative positions of the reticle positioning assembly and the substrate positioning assembly to the upper and lower portions of the image reduction assembly, respectively, the reticle and substrate are positioned to provide the most accurate imaging from the reticle through the image reduction assembly and to the substrate. Consequently, an imaging system that uses at least two interferometer assemblies as described above is a highly preferred imaging system.

The imaging assembly of an imaging apparatus is preferably an image reduction assembly in which the image on the reticle is reduced in size when the image is projected on the substrate. However, the imaging assembly may instead transfer an image to the substrate without magnification or reduction, or the imaging assembly may project a magnified image onto the substrate.

The flatness of a reticle or substrate positioning assembly mirror in an imaging apparatus as illustrated in Figure 2 can be measured by the interferometer assemblies 100 and 100' using a method as described in U.S. Patent No. 5,363,196, which is incorporated by reference in its entirety herein. The two interferometers of each interferometer assembly 100 and 100' that direct light to the reticle positioning assembly mirrors or the substrate positioning assembly mirrors are used when flatness is to be measured. The flatness measurements for the mirror can be stored in memory and used to further correct the positions indicated by the interferometer assembly, providing a greater degree of accuracy to the imaging system.

For example, the x axis interferometer assembly 100 of Figure 2 is used to map the undulations and changes in flatness of mirror 211 by moving the mirror in the y direction and noting the readings from the various interferometers as the mirror moves. Two interferometers in interferometer assembly 100' monitor both the distance along the y axis that the reticle positioning assembly has moved and any rotation of reticle positioning assembly 210 about an axis in the z direction. Rotation is controlled by moving the individual actuators that move the reticle positioning assembly so that the two interferometers of interferometer assembly 100' indicate the same distance from mirror 212 to each interferometer. The two interferometers of interferometer assembly 100 that illuminate mirror 211 provide measurements of the distance from each interferometer to the surface of mirror 211. As mirror 211 moves in the y direction, the readings from the interferometers of interferometer assembly 100 are stored in a database as a function of the distance in the y direction measured by the two interferometers of interferometer assembly 100'. Likewise, mirror 212 for the y axis interferometer assembly 100' can be mapped by moving mirror 212 in the x direction and noting the readings from the various interferometers as a function of how much the mirror has been moved in the x direction.

The mirror flatness maps thus created are used to correct distance measurements as the imaging apparatus is used to project images upon the substrate. The mirror flatness values for a particular x and y position are added to the values of the desired position of the reticle positioning assembly to provide reticle positioning that accounts for variations in mirror flatness and thus provides more accurate placement of the reticle relative to the image reduction assembly.

Simple geometry is used to calculate surface flatness and how much relative movement, if any, has occurred when mapping mirror flatness. Each beam splitter is positioned in fixed relation to one another because of the high rigidity of the housing to which the interferometers are mounted, so the distance between beam splitters of the various interferometers is known. These known distances are used as the basis for calculating distances measured by the interferometers. The high rigidity of the housing assures that there is essentially no movement of any of the interferometers relative to any of the other interferometers mounted in the housing.

Certain preferred embodiments have been described to help illustrate the invention. Other embodiments are now readily apparent to those of ordinary skill in the art, and the claims are to be given their broadest reasonable interpretation to include these embodiments in view of the principles and embodiments described herein.

## Claims

1. An interferometer assembly configured to provide accurate positioning of a reticle stage or a wafer stage to an image reduction assembly, the interferometer assembly comprising a rigid housing and at least three interferometers mounted rigidly on said rigid housing and positioned two-dimensionally with respect to one another, said rigid housing being reinforced to prevent flexing, and said at least three interferometers being mounted closely to one another on said rigid housing.

2. The interferometer assembly of claim 1 wherein said interferometer assembly comprises at least five interferometers.

3. The interferometer assembly of claim 1 wherein said rigid housing comprises a thick-walled box assembly having walls to which said interferometers are rigidly attached.

4. The interferometer assembly of claim 2 wherein said rigid housing comprises a thick-walled box assembly having walls to which said interferometers are rigidly attached.

5. The interferometer assembly of claim 1 wherein said interferometers are positioned in an orthogonal array on said rigid housing.

6. The interferometer assembly of claim 2 wherein said interferometers are mounted on said rigid housing in at least two rows and at least one column.

7. The interferometer assembly of claim 2 wherein a first subset of said interferometers, comprised of at least three of said interferometers, is positioned on said housing to determine the orientation of a first planar surface in space, and wherein a second subset, comprised of at least two additional of said interferometers, is positioned to determine the change in distance to a second planar surface at the same elevation along said second planar surface.

8. The interferometer assembly of claim 7 wherein said second subset comprises at least three additional of said interferometers.

9. An imaging apparatus for lithographic transfer of an image to a substrate, said imaging apparatus comprising a reticle positioning assembly, a substrate positioning assembly, an imaging assembly, and at least one interferometer assembly positioned to determine relative movement between said reticle positioning assembly and said image reduction assembly or between said substrate positioning assembly and said image reduction assembly, wherein said interferometer assembly comprises a rigid housing and at least three interferometers mounted rigidly within said rigid housing and positioned two-dimensionally with respect to one another, said rigid housing being reinforced to prevent flexing.

10. The imaging apparatus of claim 9 wherein the imaging assembly comprises an image reduction assembly.

11. The imaging apparatus of claim 10 wherein said interferometer assembly is attached to a mounting surface that is not a part of said image reduction assembly.

12. The imaging apparatus of claim 11 wherein said interferometer assembly is attached to said mounting surface through at least three mounts configured to substantially isolate flexing of the mounting surface from the interferometer assembly.

13. The imaging apparatus of claim 12 wherein each of said mounts forms a portion of a corresponding gimbal.

14. The imaging apparatus of claim 13 wherein each of said mounts comprises a body, a cross flexure on one end of said body, and a single flexure on a second end of said body, said cross flexure being mounted to said interferometer assembly and said single flexure being mounted to an interferometer assembly support.

15. An imaging apparatus useful for lithographic transfer of an image to a substrate, said imaging apparatus comprising a reticle positioning assembly, a substrate positioning assembly, an imaging assembly, and at least two interferometer assemblies of claim 2, wherein a first of said interferometer assemblies is positioned to determine relative movement between said reticle positioning assembly and an upper portion of said image reduction assembly and wherein a second of said interferometer assemblies is positioned to determine relative movement between said substrate positioning assembly and a lower portion of said image reduction assembly.

16. The imaging apparatus of claim 15 wherein said imaging assembly comprises an image reduction assembly.

17. The imaging apparatus of claim 16 further comprising
a) a third interferometer assembly positioned to determine relative movement between said reticle positioning assembly and said upper portion of said image reduction assembly, said movement as measured by the third interferometer assembly being in a direction that differs from the direction of movement measured by the first interferometer assembly; and
b) a fourth interferometer assembly positioned to determine relative movement between said substrate positioning assembly and said lower portion of said image reduction assembly, said movement as measured by the fourth interferometer assembly being in a direction that differs from the direction of movement measured by the second interferometer assembly.

18. The imaging apparatus of claim 17 wherein said imaging apparatus further comprises an illuminator positioned so that light generated by said illuminator illuminates at least a portion of a reticle carried in said reticle positioning assembly.

19. The imaging apparatus of claim 17 wherein said imaging apparatus further comprises an electron-beam generator positioned so that electron beams generated by said electron-beam generator illuminate at least a portion of a reticle carried in said reticle positioning assembly.

20. A method of accurately forming an image on a substrate carried by a substrate positioning assembly using lithographic equipment that has a reticle positioned on a reticle positioning assembly and an image reduction assembly, said method comprising
a) illuminating at least a portion of the reticle with radiation such that said radiation passes through the reticle and through the image reduction assembly to the substrate on which said image is to be formed;
b) moving the reticle by repositioning the reticle positioning assembly using a first interferometer assembly of claim 2 to determine the position of said reticle positioning assembly;
c) moving the substrate by repositioning the substrate positioning assembly using a second interferometer assembly of claim 2 to determine the position of said substrate positioning assembly; and
d) illuminating said reticle with said radiation.

21. The method of claim 20 wherein the act of moving the reticle further comprises repositioning the reticle positioning assembly using a third interferometer assembly to determine the position of said reticle positioning assembly in a direction that differs from the direction along which the first interferometer assembly measured; and wherein the act of moving the substrate further comprises repositioning the substrate positioning assembly using a fourth interferometer assembly to determine the position of said substrate positioning assembly in a direction that differs from the direction along which the second interferometer assembly measured.
